## Europäisches Patentamt

## European Patent Office

## Office européen des brevets

(19)

(11) Publication number: **0 163 956**
A2

# EUROPEAN PATENT APPLICATION

(12)

(21) Application number: **85105442.9**

(51) Int. Cl.⁴: **H 01 L 27/14**

(22) Date of filing: **03.05.85**

(30) Priority: **04.05.84 US 607153**
**04.12.84 US 678105**
**20.03.85 US 713928**

(43) Date of publication of application: **11.12.85**
**Bulletin 85/50**

(84) Designated Contracting States: **AT BE CH DE FR GB IT LI LU NL SE**

(71) Applicant: **ENERGY CONVERSION DEVICES, INC., 1675 West Maple Road, Troy Michigan 48084 (US)**

(72) Inventor: **Cannella, Vincent D., 18625 Devonshire, Birmingham Michigan 48009 (US)**
Inventor: **Catchpole, Clive, 31050 Stafford Drive, Birmingham Michigan 48010 (US)**
Inventor: **Keem, John E., 141 Lone Pine Road, Bloomfield Hills Michigan 48013 (US)**
Inventor: **Swartz, Louis D., 5695 Groveland Road, Holly Michigan 48442 (US)**
Inventor: **Yaniv, Zvi, 27610 Arlington Court, Southfield Michigan 48076 (US)**

(74) Representative: **Müller, Hans-Jürgen, Dipl.-Ing. et al, Müller, Schupfner & Gauger Lucile-Grahn-Strasse 38 Postfach 80 13 69, D-8000 München 80 (DE)**

(54) **Intergrated radiation sensing array.**

(57) An incident radiation sensing apparatus is provided which comprises an array of radiation sensitive elements, such as photovoltaic cells or photoresistors, formed as an integrated circuit on a substrate. Preferably crossing address lines are used to read the elements, and isolation devices, such as diodes, make the elements individually readable. A conversion means, for converting from a second form of radiant energy to a first form to which the sensing elements of the invention respond, can be placed over those elements, enabling them to sense images in the second form of radiation. The invention can be used as a contact-type document scanner. The invention can also be used to integrate the amount of radiation which falls upon its sensors, greatly increasing its sensitivity.

Claim(s) Nr (*)        deemed
to be abandoned

(*) 13 through 20, 24, 31, 33 through 47,
52, 56 through 64, 66, 67, 69, and 75

INTEGRATED RADIATION SENSING ARRAY

## FIELD OF THE INVENTION

The present invention relates to electronic radiation sensing devices, and more particularly to solid-state integrated arrays of electronic radiation sensing elements suitable for sensing spatial patterns of varying radiation intensity, such as those associated with light images, for example, images of documents, x-ray images, or images produced by high energy radiation.

## BACKGROUND OF THE INVENTION

Electronic radiation sensors have been used in the past for many purposes. They have been commonly used for image sensing in television and video tape cameras, in robotic vision, in aerial reconnaissance, and in document scanning, such as that performed in facsimile machines.

Systems are known for converting an image, such as characters of a document into electrical signals which can be stored in a memory for later recall or transmitted to a remote location over, for example, telephone communication or similar systems. Systems of this type have generally been referred to as line scanners. In one type of line scanner, the documen is held stationary and a photodetector or detectors are scanned across each line of the document along with a localized light source. In another type of scanner, the photodetector and light source are held stationary and the documen is moved. In both types of systems, as the document is scanned, the high optical density or dark portions of the document reflect less lgiht from the light source into the detector than the low optical density or light portions. As a result, the high and low optical density portions can be contrasted by the photodetector for generating electrical signals representative of the character images of the document.

While systems of the type above have been generally successful in fulfilling their intended purposes and have found commercial acceptance, these systems have exhibited several deficiencies. For example, line scanner systems are rather complex. They require mechanical drive and servo systems to precisely control the movement of the photosensor and light source relative to the document being scanned to enable accurate data storage or transmission of the electrical signals for the ultimate faithful reproduction of the document.

Another important type of prior art image sensing devices includes television camera tubes, such as the well known vidicon and plumbicon tubes. Unfortunately, however, although vidicon and plumbicon tubes produce excellent images, they tend to be relatively bulky, fragile, and expensive since they are glass vacuum tubes. Thus, there has been a demand for a solid-state sensing device.

One such solid state device provided by the prior art is the charged-coupled device, or CCD. CCD's have many advantages. They are relatively small and rugged. They also have the advantage of having the position of their photosensitive elements determined in a fixed manner by the location of their imaging electrodes, rather than being determined in a less reliable dynamic manner by the electronic deflection circuitry used in video tubes of the type described above. But CCD technology does not appear suited for all applications. For example, the signal produced in its individual photosensitive elements is not randomly addressable, since the signal contained in a given line of such photosensitive elements is read out serially in a shift register. Additionally, charge-coupled devices have traditionally been made on crystalline substrates. Because of the present limitations on the size in which such crystalline substrates can be manufactured, and because of the large cost of such crystalline substrates, charge-coupled device technology is not suited for large area arrays of image sensors, such as those which might be used in contact type document copiers.

125.2

0163956

## SUMMARY OF THE INVENTION

The invention provides a new and improved solid-state apparatus and method for providing electrical signals representative of an image.

According to one embodiment, the present invention provides an apparatus for providing electrical signals representative of an image thereon which includes an array of spaced apart, light sensitive elements formed from deposited semiconductor material and arranged for receiving said image. The elements are capable of effecting a detectable electrical characteristic responsive to the intensity of light received thereon from the image. The apparatus further includes isolation means, such as diodes, for enabling the selective detection of the electrical characteristics of each element.

In one preferred embodiment, the invention provides an apparatus in the form of a contact-type page scanner for providing electrical signals representative of an image having light and dark portions carried by an image-forming member. The apparatus includes a transparent substrate, a first set of address lines, and a second set of address lines spaced from and crossing at an angle to the first set of address lines to form a plurality of crossover points. The apparatus further include a plurality of light sensitive elements formed and distributed on the substrate and in spaced apart relation, each light sensitive element being associated with a given one of the crossover points and arranged to effect a detectable change in electrical conductivity in response to receipt of incident light, and an isolation device associated with each light sensitive element to facilitate the selective addressing and detection of the electrical conductivity of each light sensitive element by the application of read potentials to respective pairs of the first and second sets of address lines. The apparatus further includes transparent cover means overlying the light sensitive elements and including a substantially planar surface opposite the light sensitive elements for receiving the image-bearing member thereon in close juxtaposed relation to the light sensistive elements.

The light sensitive elements can comprise, for example, photovoltaic cells or photoresistors. The light sensitive elements can be formed from deposited semiconductor material, and preferably from an amorphous semiconductor alloy.

The isolation devices can comprise diodes or field effect transistors, for example. The isolation devices can also be formed from deposited semiconductor material and preferably an amorphous semiconductor alloy.

The present invention further provides a method of generating electrical signals representative of an image formed by high and low optical density portions on one side of an image-bearing member. The method includes the steps of providing an array of light sensitive elements capable of effecting a detectable change in electrical conductivity responsive to the receipt of light thereon in spaced apart substantially coplanar relation, placing the image-bearing member over the array of elements with the one side of the member adjacent the array of elements, projecting light onto one side of the member so that the image portions of low optical density reflect light onto the elements adjacent thereto and the image portions of high optical density reflect substantially less light onto the elements adjacent thereto, and selectively applying read potentials to

725.2

the light sensitive elements for detecting the electrical conductivity of the elements and deriving an electrical signal for each element representative of the optical density of the image portion adjacent thereto.

Preferably, the one side of the image-bearing member is placed in closely spaced, juxtaposed relation to the array of elements and the light is projected onto the one side of the image-bearing member through the spaces between the elements.

The present invention further provides an apparatus for providing electrical signals which also represent the color hues of an image. To that end, primary colored light sources of red, green, and blue light can be sequentially projected onto the image-bearing member. The electrical signals provided by each light sensitive element can thereafter be correlated to derive the proper color hue of the portion of the image-bearing member adjacent each light sensitive element.

According to another aspect of the invention, converting means for converting radiation having one energy value into radiation having another energy value is placed over the light sensitive or similar radiation sensitive elements of arrays of the general type described elsewhere in this Summary of the Invention. In a preferred embodiment, the converting means includes a layer of phosphorescent material. The phosphorescent material is positioned between a grounded metal layer and a transparent insulating layer. The insulating layer, preferably silicon dioxide, overlies the array of energy sensitive elements. The enrgy converter converts a first form of energy, (such as x-rays), with photon or particle energy in a first energy range into a second form of energy, (such as visible light), with photon or particle energies in a second range. The first form of energy can be not only radiant electromagnetic energy, such as x-rays, but could also be an accelerated particle beam, such as an accelerated beam of electrons. Alternately, the converting means can be formed of a layer of fluorescent material placed in close proximity to the array of photosensitive elements.

In accordance with yet another aspect of the invention, an incident radiation sensing apparatus is provided which integrates incident radiation to produce a stronger signal in response to such integration. This integrating radiation sensing apparatus comprises a substrate and an array of photosensitive elements formed as an integrated circuit on the substrate. Each of the photosensitive elements includes a capacitor means for storing charge, a conductive means for charging the capacitor means to a preselected magnitude, and a blocking means for inhibiting the discharge of charge stored on the capacitor means. Each of the photosensitive elements further includes a photosensitive means formed from deposited semiconductor material for generating charge carriers at a rate responsive to the intensity of radiation incident upon the photoresponsive means. The photoresponsive means associated with each of the photosensitive elements is connected to the capacitor means associated with that element, so that the charge carriers produced in response to incident radiation reduce the magnitude of the charge on the capacitor means as a function of the magnitude of, and the time incidence of, the incident radiation. The radiation sensing apparatus further includes means for sensing the magnitude of charge remaining on a given capacitor means a preselected period of time after its charging by the conductive means, so as to produce a signal corresponding to the time integral of the magnitude of the incident radiation impinging upon the photoresponsive means connected to its associated capacitor means during the preselected period of time.

In a preferred embodiment of the invention, the integrating radiation sensing apparatus includes a plurality of intersecting lines formed on its substrate, and the conductive means associated with each of the photosensitive elements includes a pair of such intersecting lines. Preferably, the means for sensing the magnitude of charge remaining on the capacitor means a preselected time after its charging also includes the same pair of intersecting lines associated with each photosensitive element as is included in the conductive means. Normally the plurality of intersecting lines includes a plurality of generally parallel x lines and a plurality of generally parallel y lines crossing the x lines. When this is the case, the photosensitive elements are formed at the crossing of the x and y lines and the conductive means associated with each photosensitive element includes one x line and one y line.

In the preferred embodiment of the integrating radiation sensing apparatus, the blocking means for inhibiting the discharge of charge stored on the capacitor means is connected between the capacitor means and a part of the conductive means, so as to inhibit the discharge of the capacitor means through the conductive means. This blocking means normally includes a semiconductor blocking junction, such as that of a diode.

In the preferred embodiment, the conductive means for charging the capacitor means to a preselected magnitude further includes means for recharging the capacitor means after the expiration of the preselected period of time, and the means for sensing the magnitude of charge remaining on a capacitor means a preselected period of time after its charging includes means for sensing the amount of current which flows during such a recharging of the capacitor means.

In preferred embodiments of the integrating sensing apparatus, the capacitor means is a capacitor formed of two spaced apart electrodes and the deposited semiconductor material of the photoresponsive means is located between and is electrically connected to those electrodes. In the preferred embodiment, these electrodes are vertically arrayed with respect to each other and the substrate and the semiconductor material of the photoresponsive means is deposited between the electrodes so as to act as a dielectric between them. In the preferred embodiment the semiconductor material of the photoresponsive means includes an amorphous semiconductor alloy, such as an alloy of silicon including either hydrogen or fluorine or both. In the preferred embodiment the deposited semiconductor material forms at least one semiconductor blocking junction which inhibits the discharge of the capacitor in the absence of radiation incident upon the semiconductor material. For example, in certain preferred embodiments, deposited semiconductor material is formed of at least two layers which have their fermi levels positioned differently relative to the energy levels of their respective conduction and valance bands, so as to form one or more blocking junctions. In one embodiment the deposited semiconductor material includes three layers, a bottom layer closest to the substrate formed of a first conductivity type, an intermediate layer formed of a substantially intrinsic type, and a top layer formed of a second conductivity type, with the first and second conductivity types being selected so that the resulting semiconductor junctions between the layers form blocking junctions which inhibit the discharge of the capacitor in the absence of radiation incident upon the semiconductor material. According to certain other preferred embodiments at least one of the electrodes of the capacitor includes a metal which forms a blocking junction which inhibits the discharge of the capacitor when placed in contact with the semiconductor material of the photoresponsive means.

According to another embodiment of the integrating sensing apparatus, the semiconductor material which is deposited between the electrodes of the capacitor functions as a photoresistor, blocking the discharge of the capacitor by the high resistivity of the semiconductor material in the absence of the incidence of light upon it. In such an embodiment, the deposited semiconductor material is preferably formed of a single layer of substantially intrinsic amorphous semiconductor material.

According to another embodiment, the integrating radiation sensing apparatus of the present invention is used in a contact-type page scanner similar to the page scanners described above. Preferably, the integrated circuit in which the array of photosensitive elements is formed is a large area integrated circuit at least 11" long and 8-1/2" wide, and the integrated circuit is formed so that light can pass through spaces between the photosensitive elements to illuminate a portion of the document placed in close proximity to each photosensitive element without directly illuminating the photosensitive element itself.

In yet another embodiment of the invention, integrating radiation sensing apparatus of the type described above is provided which includes a focusing means for focusing a light image upon its array of photosensitive elements.

## BRIEF DESCRIPTION OF THE DRAWINGS

In the drawings, which form an integral part of the specification and which are to be read in conjunction therewith, and in which like reference numerals are employed to designate similar components in various views:

Figure 1 is a partial side view, partly in cross section, of a contact-type document scanner system and apparatus embodying the present invention with a document to be scanned disposed over the apparatus;

Figure 2 is a top plan view of the contact-type scanner of Figure 1 with the document removed;

Figure 3 is a partial cross-sectional side view illustrating a light sensitive element and an isolating device associated therewith embodying the present invention;

Figure 4 is a top plan view of the light sensitive element and isolating device of Figure 3;

Figure 5 is an equivalent circuit diagram of the light sensitive element and isolating device of Figure 3;

Figure 6 is a partial cross-sectional side view of another light sensitive element and isolating device embodying the present invention; and

Figure 7 is the equivalent circuit diagram of the light sensitive element and isolating device of Figure 6;

Figure 8 is a partial cross-sectional side view illustrating a light sensitive element similar to that shown in Figure 3, except that an energy conversion means has been placed over its photosensitive elements;

Figure 9 is a partial cross-sectional side view of another light sensitive element similar to that shown in Figure 6, except that an energy conversion means has been placed over its photosensitive elements;

Figure 10 is a schematic circuit diagram of an integrating radiation sensing apparatus according to another embodiment of the present invention;

Figures 11a through 17a are schematic representations indicating the voltages applied to the row and column address lines of the integrating radiation sensing apparatus shown in Figure 10, and Figures 11b through 17b are schematic circuit diagrams of the photosensitive element contained in the upper left hand corner of the array shown in Figure 10, indicating the voltages of its various elements during the various phases of the scanning sequence shown in the corresponding Figures 11a through 17a;

Figure 18 is a partial top plan view of an integrated circuit in which an array of photosensitive elements have been formed according to an embodiment of the present invention;

Figure 19 is a partial cross-sectional side view of the integrated circuit shown in Figure 18 taken along the line of 19-19 in that figure;

Figure 20 is a partial cross-sectional side view of the integrated circuit shown in Figure 18 taken along the line 20-20 shown in that figure;

Figure 21 is a partial cross-sectional side view of an integrated circuit similar to that shown in Figure 20 except that the diode formed by its semiconductor layer is a Schottky diode formed by the contact of that semiconductor layer with its bottom metal layer, rather than a PIN diode as in Figure 20;

Figure 22 is a partial cross-sectional side view of an integrated circuit similar to that shown in Figure 20, except that the semiconductor region associated with its photosensitive element does not form a diode, but instead acts as a photoresistor;

Figure 23 is a partial cross-sectional side view of an integrated circuit substantially identical to that shown in Figure 20 except that it is covered with a layer of fluorescent material;

Figure 24 is a cross-sectional side view of an incident radiation sensing apparatus according to the present invention for use in forming an image of a document placed in close proximity to its array of photosensitive elements, with a portion of such a document being shown;

Figure 25 is a cross-sectional side view of an incident radiation sensing apparatus according to the present invention which includes focusing means for focusing a light image upon its array of photosensitive elements.

## DETAILED DESCRIPTION OF THE PREFERRED EMBODIMENTS

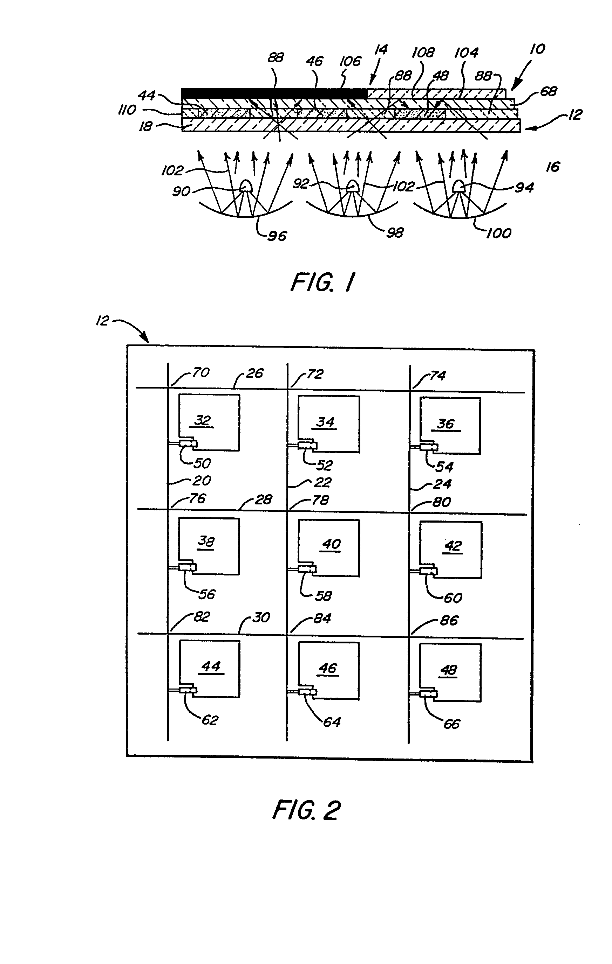

Figures 1 and 2 illustrate a contact-type document scanner system and apparatus embodying the present invention. The system 10 illustrated in Figure 1 generally includes an apparatus 12 capable of providing electrical signals representative of an image carried by an image-bearing member such as a document 14 disposed thereover, and a light source 16.

The apparatus 12 includes a transparent substrate 18, a first set of X address lines including address lines 20, 22, and 24, a second set of Y address lines including address lines 26, 28, and 30, and a plurality of light sensitive elements 32, 34, 36, 38, 40, 42, 44, 46, and 48. The apparatus 12 further includes an isolation device 50, 52, 54, 56, 58, 60, 62, 64, and 66 associated with each light sensitive element, and, a transparent cover means 68.

As can be noted in Figure 2, the X address lines 20, 22, and 24 and the Y address lines 26, 28, and 30 cross at an angle, and, as will be more apparent hereinafter, are spaced from one another to form a plurality of crossover points 70, 72, 74, 76, 78, 80, 82, 84, and 86. Associated with each of the crossover points is a respective one of the light sensitive elements. The light sensitive elements 32-48 are formed on the substrate 18 and are distributed thereover in spaced apart relation to form spaces 88 between the light sensitive elements. The light sensitive elements 32-48 are further of the type which effects a detectable electrical characteristic in response to the receipt of light thereon. As will be more fully described hereinafter, the light senstive elements 32-48 can comprise photovoltaic cells or photoresistors which effect a detectable change in electrical conductivity in response to the receipt of incident light thereon. The light sensitive elements are preferable formed from a deposited semiconductor material, such as, an amorphous semiconductor alloy. Preferably, the amorphous semiconductor alloy includes silicon and hydrogen and/or fluorine. Such alloys can be deposited by plasma-assisted chemical vapor deposition, i.e., glow discharge, as disclosed, for example, in U.S. Patent No. 4,226,898 which issued on October 7, 1980 in the names of Stanford R. Ovshinsky and Arun Madan for "Amorphous Semiconductors Equivalent To Crystalline Semiconductors Produced By A Glow Discharge Process", which patent is hereby incorporated by reference.

Each of the isolating devices 50-66 is associated with a respective one of the light sensitive elements 32-48. The isolation devices are also preferably formed from a deposited semiconductor material, and most preferably, an amorphous semiconductor alloy including silicon. The amorphous silicon alloy can also include hydrogen and/or fluorine and can be deposited by plasma-assisted chemical vapor deposition as disclosed in the aforementioned U.S. Patent No. 4,226,898. As can be noted in Figure 2, each of the isolation devices 50-66 is coupled in series relation with its associated light sensitive element 32-48 between respective pairs of the X address lines 20, 22, and 24 and the Y address lines 26, 28, and 30. As a result, the isolation devices facilitate the selective addressing and detection of the electrical conductivity of each of the light sensitive elements by the application of read potentials to respective pairs of the X and Y address lines.

Referring now more particularly to Figure 1, as can there be noted, the light source 16 comprises a plurality of individual light sources 90, 92, and 94. Associated with each of the sources 90, 92, and 94 is a reflector 96, 98, and 100. The light sources 90, 92, and 94 and the reflectors 96, 98, and 100 are arranged to provide diffuse light indicated by the arrows 102 which is projected onto the apparatus 12 on the side of the substrate 18 opposite the light sensitive elements and the document 14 to be scanned. The document 14 is disposed over the transparent cover 68 which includes a substantially planar surface 104. The document 14 includes at least one portion 106 of high optical density, hereinafter referred to as the dark portions of the document, and portions 108 which are of low optical density, and are hereinafter referred to as the light portions of the document. The cover 68 is preferably relatively thin so that the document 14 is closely spaced in juxaposed relation to the light sensitive elements, such as, light sensitive elements 44, 46, and 48 illustrated in Figure 1. The thickness of the cover 68 is chosen to give maximum useable signal consistent with a number of other variable parameters. These parameters include the angular distribution of the diffuse light intensity, the width of the light sensitive elements, and the spacing between the light sensitive elements. Preferably, the thickness of the cover 68, the width of the light sensitive elements, and the spacing between the light sensitive elements are all of comparable dimension.

The cover 68 is adhered to the substrate 18 by a transparent adhesive 110. The adhesive 110 is preferably a material having an index of refraction which matches the index of refraction of the substrate 18 to that of the cover 68 to miximize the reflection from the surface boundaries bordered by the matching material.

When the document 14 is to be scanned, it is first placed over the apparatus 12 in substantial contact with the planar surface 104 of the transparent cover 68 so that the document is disposed in closely spaced juxtaposed relation to the light sensitive elements. Then, the light source 16 is energized for projecting the diffuse light 102 onto the back side of the apparatus 12. The diffuse light is thereby projected onto the surface of the document 14 adjacent the planar surface 14. In the dark protions 106 of the document 14, the light will be substantially absorbed so that very little of the light impinging upon the dark portions 106 will be reflected back onto the light sensitive elements adjacent thereto, for example, light sensitive elements 44 and 46. However, the light striking the light portions 108 will not be substantially absorbed and a substantially greater portion of the light impinging upon the light portions 108 of the document will be reflected back onto the light sensitive elements adjacent thereto, such as light sensitive element 48. The light sensitive elements adjacent the light portions 108 of the document will thereby effect a detectable change in their electrical conductivity. When the light sensitive elements are formed from photovoltaic cells, they will not only effect a change in electrical conductivity, but will also generate current. When the light sensitive elements are photoresistors, they will effect an increased electrical conductivity which can be detected by the application of read potentials to the respective pairs of the X address lines 20, 22, and 24, and the Y address lines 26, 28, and 30.

Electrical signals representing a faithful reproduction of the document 14 can be obtained because the light sensitive elements 32-48 can be made very small. For example, the light sensitive elements can be made to have dimensions of approximately 90 microns on a side. The isolating devices 50-66 can be formed to have a dimension of about 10-40 microns on a side and preferably 20 microns on a side. Also, the light sensitive elements 32-48 can be spaced apart so that they cover only a portion of the substrate 12 to permit the light to be projected onto the document to be scanned. For example, the light sensitive elements can be spaced so that they cover about 25-50% of the overall surface area of the substrate 18. Also, the light sensitive elements can be arranged in substantially coplanar relation so that each will be equally spaced from the document to be scanned. Although Figure 2 illustrates a 3 x 3 matrix of light sensitive elements, it can be appreciated that a much larger array of elements would be required in actual practice for scanning a document.

The electrical characteristic, and, in accordance with this preferred embodiment, the electrical conductivity of the light sensitive elements can be detected by applying read potentials to respective pairs of the X and Y address lines in series, and one at a time. However, and most preferably, the light sensitive elements can be divided into groups of elements and the read potentials can be applied to each group of elements in parallel to facilitate more rapid scanning of the document. Within each group of elements, the elements can be scanned in series.

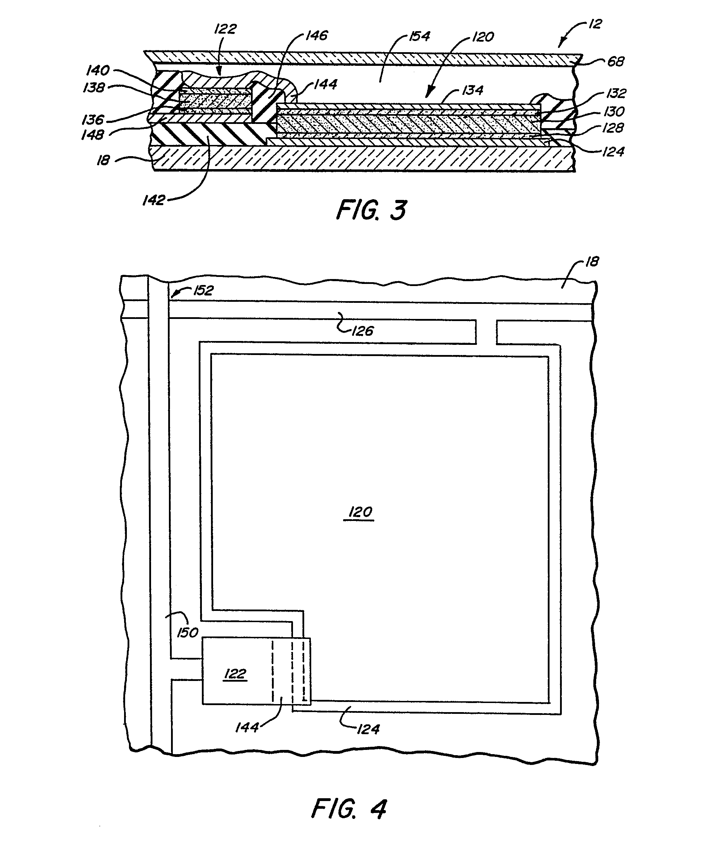

Referring now to Figures 3 and 4, they illustrate in greater detail a configuration of light sensitive element 120 and isolation device 122 in accordance with the present invention. Here, the apparatus 12 includes the transparent or glass substrate 18. Formed on the substrate 18 is a metal pad which is electrically connected to a Y address line 126. The metal pad 124 can be formed from aluminum, chromium, or molybdenum, for example.

Formed on the metal pad 124 is the light sensitive element 120 which can take the form of a photovoltaic cell. The photovoltaic cell or light sensitive elements 120 can include an amorphous silicon alloy body having a first doped region 128, an intrinsic region 130, and a second doped region 132. The regions 128 and 132 are preferably opposite in conductivity wherein the region 128 is p-tye and the region 132 is n-type. Overlying the n-type regions 132 is a layer of a transparent conductor 134.

Photovoltaic cells of this type are fully disclosed, for example, in the aforementioned U.S. Patent No. 4,226,898 and therefor need not be described in detail herein.

The metal pad 124 not only forms an ohmic contact with the light sensitive element 120 but in addition, serves to block light from reaching the back side of the light sensitive element. This function of the metal pad 124 is particularly important when the scanning system is to be used in accordance with the embodiment illustrated in Figure 1.

The isolation device 122, in accordance with this embodiment, comprises a diode, also formed from an amorphous silicon alloy having a p-type region 136, an intrinsic region 138, and an n-type region 140. The diode 122 is also formed on a metal pad 148 which is formed on a layer of a deposited insulator 142 which can be formed from, for example, silicon oxide or silicon nitride. The diode 122 can be formed during the same deposition as the photovoltaic device 120.

The diode 122 is coupled to the photovoltaic cell 120 by an interconnect lead 144. Separating the diode 122 from the photovoltaic cell 120 is a deposited insulator 146 which can also be formed from silicon oxide or silicon nitride.

The metal pad 148 is coupled to an X address line 150. As can be noted in Figure 3, the X address line 150 and the Y address line 126 are spaced apart by the insulating layer 142. Because the address lines cross at an angle and are separated from one another, an insulated crossover point 152 is thereby formed.

The structure of Figure 3 is completed by the transparent cover member 68 which can be formed from glass.  It is disposed over the diode and light sensitive element and is adhered thereto by a transparent adhesive which can fill the space 154.  As previously mentioned, the transparent adhesive preferably has an index of refraction which matches the index of refraction of the glass substrate 18 to that of the cover member 68.

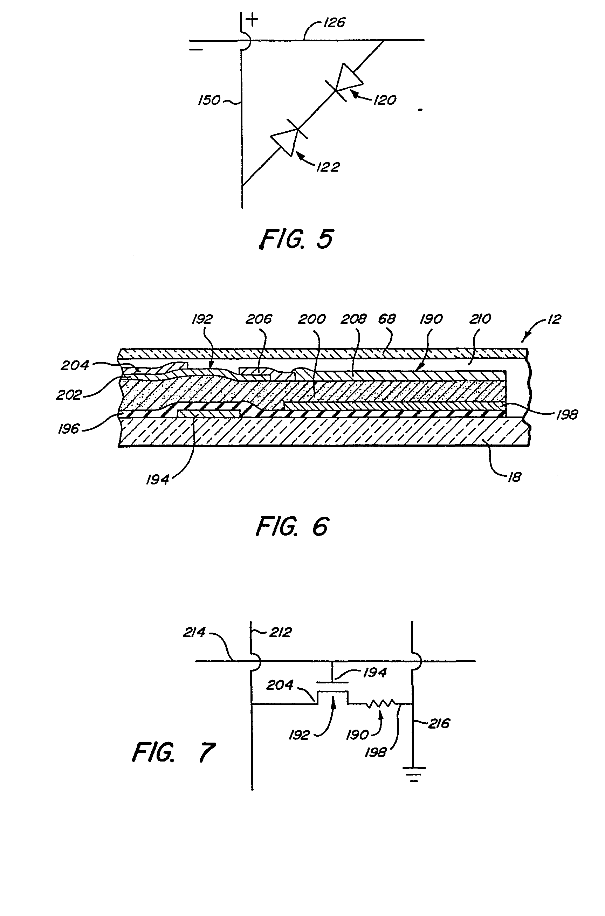

Referring now to Figure 5, it illustrates the equivalent circuit diagram of the light sensitive element 120, the isolating diode 122, and the address lines 126 and 150.  It can be noted that the interconnect lead 144 connects the cathodes of the photovoltaic cell 120 and diode 122 together.  The anode of the diode 122 is coupled to the X address line 150 and the anode of the photovoltaic cell 120 is coupled to the Y address line 126.  It is to be understood that the diodes formed by the isolation device 122 and the photovoltaic cell 120 can be connected in an opposite polarity so that their anodes rather than their cathodes touch.

In order to read the electrical characteristic of the photovoltaic cell 120, a positive potential is applied to the X address line 150 and a negative potential is applied to the Y address line 126.  This forward biases the isolating diode 122.  If light is being reflected off of a light portion of the document being scanned onto the photovoltaic cell 120, a photogenerated current will be produced within the cell 120 and will be detected through the forward biased diode 122.  However, if the cell 120 is adjacent one of the dark portions of the document, substantially no photogenerated current will be produced by the cell 120.  The difference between the two current levels can therefor be contrasted for deriving an electrical signal representative of the image adjacent the cell 120.

Referring now to Figure 6, it illustrates a further configuration of light sensitive element 190 and isolation device 192. Here, the light sensitive element takes the form of a photoresistor and the isolating device 192 takes the form of a thin film field effect transistor.

The apparatus 12 illustrated in Figure 6 includes a transparent substrate 18, which can be formed from glass, for example. The gate of the thin film field effect transistor 192 is first formed on the substrate 18. A layer of insulating material 196 is then deposited over the gate 194 and the substrate 18. A metallic pad 198 is then formed over the insulator 196 to form one contact of the light sensitive element or photoresistor 190.

A substantially intrinsic amorphous silicon alloy layer 200 is then deposited as shown for forming the semiconductor of the thin film field effect transistor 192 and the semiconductor of the photoresistor 190. A layer 202 of n-type amorphous silicon can then be formed over the intrinsic amorphous silicon alloy 200 to enhance the ohmic contact between the source and drain electrodes 204 and 206 with the amorphous silicon alloy 200. A layer of a transparent conductor 208 can be formed over the amorphous silicon alloy 200 in contact with the transistor electrode 26 and in a corresponding configuration to the metal pad 198 to form the top contact of the photoresistor 190. The structure of Figure 6 is completed with the transparent cover 68 which can be formed from glass and a transparent adhesive filling the space 210 as previously described.

As will be noted in Figure 6, the gate 194, the electrode 204, and the bottom contact 198 of the photoresistor 190 are all vertically separated from one another. As a result, each of these elements can be connected to respective address lines while being insulated from one another. Figure 7 shows the equivalent circuit diagram of the structure of Figure 6.

In Figure 7, it can be noted that the electrode 104 of the thin film field effect transistor 192 is coupled to an X address line 212. The gate 194 of the transistor 192 is coupled to a Y address line 240. The bottom contact 198 of the photoresistor 190 is coupled to a common potential such as ground by a lead 216. As a result, the electrical conductivity of the photoresistor 190 can be sensed by the application of suitable potentials to the electrode 204 and gate 194 for turning the transistor 192 on. If light is being reflected off of a light portion of a document onto the photoresistor 190, a current will flow between the transistor electrodes 204 and 206 which can be sensed on the X address lead 212. However, if the photoresistor 190 is immediately adjacent a dark portion of the document, very little light will be projected onto the photoresistor 190 so that substantially no current will flow from the electro9de 204 to the electrode 206. In this manner, the condition of the photoresistor 190 can be detected.

In accordance with the present invention, electrical signals can be provided which represent the color hues of an image. For example, each of the light sources 96, 98, and 100 can include three separate light sources each being arranged to emit light of a different primary color of red, green, and blue. To generate the electrical signals representative of the color hues of the image, the image-bearing member 14 can be sequentially exposed to the red, green, and blue light. During each exposure, the light sensitive elements can be addressed. For example, when the document 14 is exposed to the red light, those image portions thereof which include a red color component will reflect red light onto the light sensitive elements adjacent thereto. These elements will effect a greater change in electrical conductivity than those elements adjacent image portions which do not include a red color component. After this procedure is performed for each of the red, green, and blue primary colors, the three electrical signals provided from each light sensitive element can be combined to derive both intensity and color hue of the image.

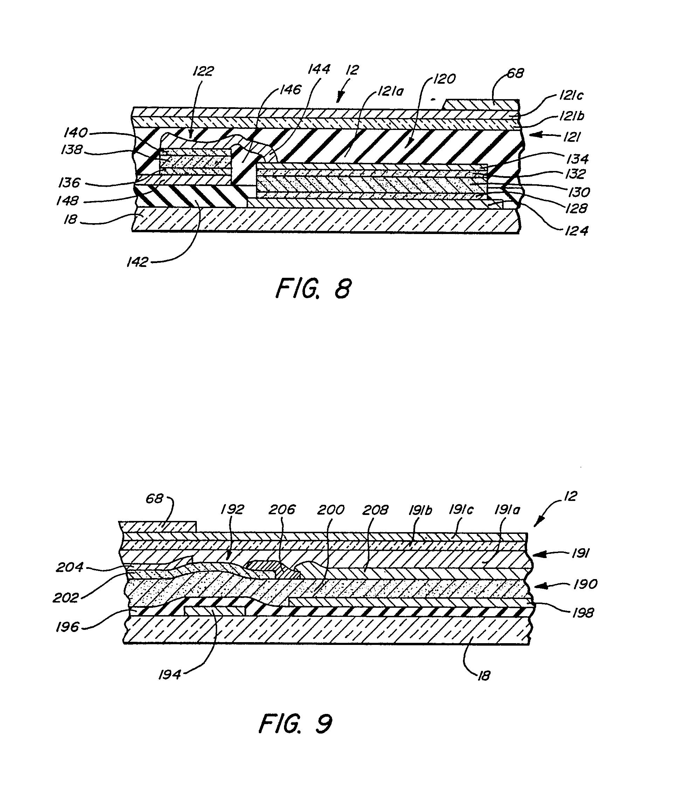

Figures 8 and 9 are similar to Figures 3 and 6 discussed above respectively, except that the photosensors shown in Figures 8 and 9 are covered by energy converting means 121 and 191, respecitively. These energy conversion means, when they are struck by radiant energy of a first energy range, such as X-rays or particle beams, emit radiation of a second energy level which can be sensed by the energy sensitive elements 120 and 190 of Figures 8 and 9, respectively.

The converter of energy 121 showin in Figure 8 includes a continuous, transparent, insulating layer 121a formed of silicon dioxide. The layer 121a can have a thickness on the order of 500 angstroms to 1 micron. The converter 121 also includes phosphorescent layer 121b formable of zinc sulfide with a thickness between 1 micron and 100 microns with 20 microns preferred. The converter 121 also includes a layer 121c of deposited metal such as aluminum that is grounded at 121d. The thickness of the metal layer 121c is between 100 angstroms and 1000 angstroms with 300 angstroms being the preferred thickness. The energy converter 121 converts X-rays, a form of electromagnetic radiation with an intensity in a first energy range into visible light, also a form of electromagnetic energy, with an intensity in a second energy range.

The structure of Figure 8 is completed by the cover member 68 which is transparent to X-rays. It is disposed over the energy converter 121 and is adhered thereto by an adhesive which is transparent to X-rays and preferably opaque to visible light.

The converter of energy 191 shown in Figure 9 is similar to the converter 121 just described. It includes a silicon dioxide insulating layer 191a, a phosphorescent layer 191b overlying the insulator 191a and a grounded conductive layer 191c overlying the phosphorescent layer 191b. A cover 68 can be affixed to the conductive layer 191c.

An alternate embodiment of the invention uses an accelerated beam of electrons in place of the X-rays disclosed above. In this alternate embodiment, the electron beam can be deflected as in a raster scanning system. As the deflected beam of electrons impinges upon the sensor elements, such as the sensor element of Figure 8, the energy of the electrons excites the phosphorescent layer 191b causing it to emit visible light as do the X-rays. The visible light is detected by the element 190. Hence, as in the embodiments of Figure 1-9, there is a conversion from a first form of energy with an intensity in a first range, that of the moving electrons, to a second form of energy with an intensity in a second energy range, that of emitted light.

In other embodiments of the invention, the energy converting layer can be made by placing a simple layer of fluorescent material over the photosensors of the array, as is described below with regard to an X-ray sensor used with the embodiment of the present invention that integrates the radiation incident upon its photosensors.

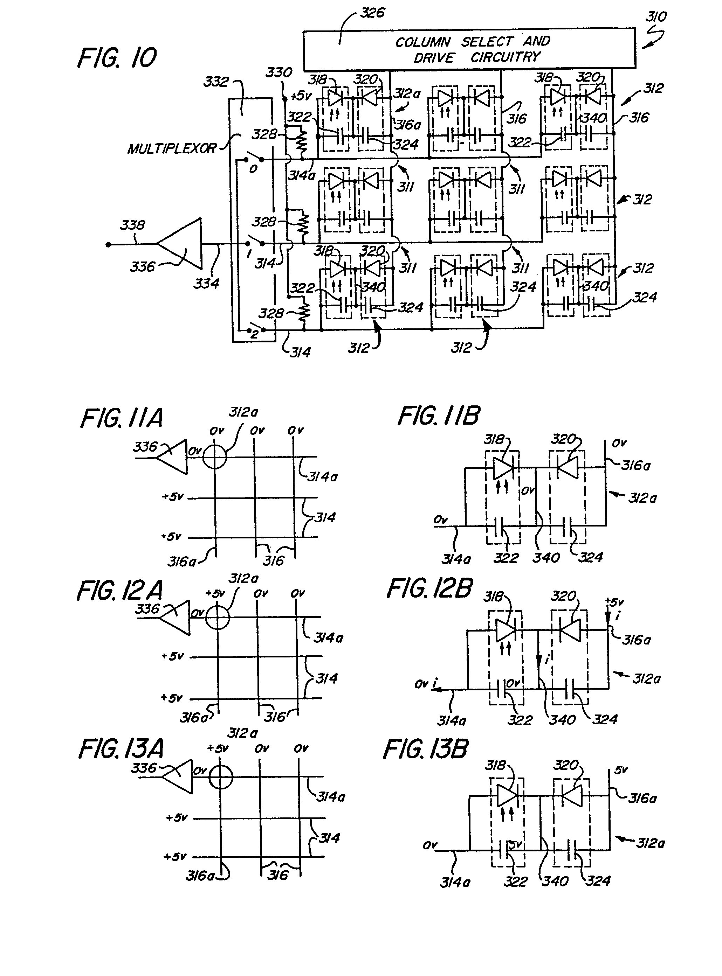

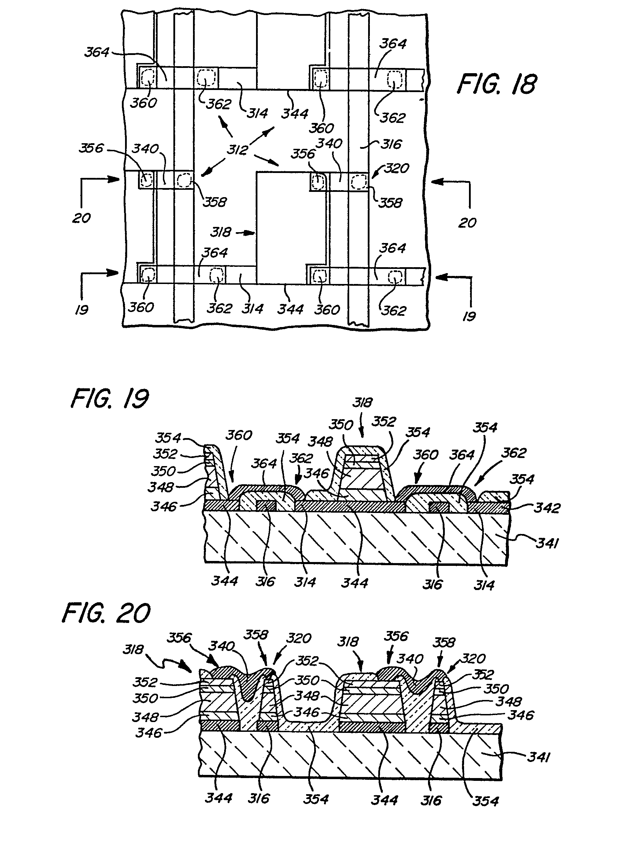

Now referring to Figure 10, the circuitry of another embodiment of the present invention is shown in schematic form. This embodiment of the invention is designed to integrate the radiation which falls upon its sensors, so as to greatly increase its sensitivity. The apparatus 310 comprises an array of photosensitive elements 312 formed as an integrated circuit on a substrate, as shown in Figures 18 through 20, below. For purposes of simplification, the array of photosensitive elements 312 shown in Figure 10 is a 3 x 3 array. However, in most embodiments of the invention much larger arrays are used.

The photosensitive elements 312 are formed at the crossings of x lines 314 and y lines 316, with one such photosensitive element connected between one x line and one y line near the intersection of those two lines. Each of the photosensitive elements includes two back-to-back diodes, a photoresponsive diode 318 and a blocking diode 320. Each of these diodes has associated with it a capacitance formed by its electrodes. The two electrodes of the photodiode 318 form a capacitor 322, and the two electrodes of the blocking diode 320 form a capacitor 324. Since the rectifying junctions of the diodes 318 and 320 are located between the electrodes of the capacitors 322 and 324, respectively, those diodes operate as if they were connected electrically in parallel with those capacitors, as is illustrated schematically in Figure 10.

The y lines 316 are driven by column select and drive circuitry 326. This circuitry provides zero volts to all of the y lines except for a selected one, to which it supplies +5 volts . The x lines 314 are each connected through a pull-up resistor 328 to a +5 volt power supply 330. Each of the x lines 314 are also connected to one input of a multiplexer 332. The multiplexer 332 connects a selected one of the x lines 314 to its output 334, which is supplied to the input of an amplifier 336. As is described below in greater detail, the output 338 of the amplifier 336 provides a signal which successively indicates the amount of light incident upon each of the photosensitive elements 312. The voltages to which the selected y line 316 and the pull-up resistors 328 are connected are both selected to be +5 volts in the embodiment illustrated, since it is a convenient voltage commonly associated with electronic circuitry. Of course, other voltage values could be used without materially affecting the invention's principles of operation.

Referring now to Figures 11a through 17a and Figures 11b through 17b, the operation of the circuitry shown in Figure 10 will be described. Figures 11b through 17b show the voltages and current flows in the photosensitive element 312a in the upper left hand corner of the 3 x 3 array shown in Figure 10. The location of this element is indicated schematically in Figures 11a through 17a by the circle surrounding the intersection between the upper most x line 314a and the left most y line 316a.

The amplifier 336 is constructed so that it drives its input to zero volts. As is well known in the electronic arts, this can be accomplished by the use of an operational amplifier with a resistive feedback loop connected between its output and its input. Such an amplifier is a current to voltage converter, often called a transconductance amplifier. The input voltage to such an amplifier typically varies by less than .001 volts, and thus such voltage variations can be ignored in this discussion. As a result of the operation of amplifier 336, the individual x line 314 which is connected at any given moment by the multiplexer 332 to the input of that amplifier has its voltage level driven to 0 volts. All the other x lines 314 have their voltage level pulled up to +5 volts by the pull-up resistors 328 connected to the +5 voltage supply 330.

Figures 11a and 11b show the state of the photosensitive element 312a before any voltages have been applied . In this initial state both the x line 314a and the y line 316a are at 0 volts, and thus the two capacitors 322 and 324 are not yet charged, and the connection 340 which joins them is at 0 volts.

When the column select and drive circuitry 326 and the multiplexer 332 select element 312a, the select and drive circuitry 326 provides +5 volts to y line 316a and 0 volts to all other y lines. During the selection of element 312a, the amplifier 336 causes x line 314a to be driven to 0 volts, while all the other x lines 314 are pulled to +5 volts through the resistors 328. This is shown schematically in Figure 12a. As is shown in Figure 12b, when this voltage scheme is first applied to the element 312a, current flows down the address line 316a and through the blocking diode 320 and the connection 340 to charge up the capacitor 322. The capacitive coupling through capacitor 322 to the x line 314a, causes a corresponding flow of current in line 314a toward the input of the operational amplifier 336. As can be seen from Figure 12b, the diode 320 is forward-biased with regard to the flow of current from the y line 316a toward the capacitor 322. Thus it provides relatively little impedance to such current. The diode 320 is designed so that the capacitance 324 of its electrodes is relatively small and thus can be substantially neglected for purposes of determining the operation of an element 312. However, as can be seen from Figure 12b, the diode 318 is reverse-biased relative to the current flowing from the y line 316a toward the x line 314a. As a result, the diode 318 offers a high impedance to the flow of such current across it, and thus the voltage drop across the diode 318 and the resulting charge across capacitor 322 is substantially equal to the +5 volt difference applied between lines 316a and 314a.

As is shown in Figures 13a and 13b, by the end of its select period, the element 312a has its capacitor 322 charged to +5 volts, preventing any further current from flowing from line 316a to line 314a other than a relatively small instantaneous reverse leakage current across diode 318. This discussion assumes for simplicity that the diodes have no voltage drop when conducting in the forward direction. The diodes actually do have a small voltage drop, but this fact does not materially affect the principles of operation taught here.

In the embodiment of the invention shown in Figure 10, the column select and drive circuitry 326 and the multiplexer 332 are normally controlled to select each of the photosensitive elements 312 in a sequential scanning method in which each row, and each elements within each row, are successively selected. Figure 12a shows the state of the element 312a during the period in which subsequent elements in its row 314a are being selected. During this period the x line 314a is still held to 0 volts by the amplifier 336, but the select and drive circuitry 326 holds the y line 316a to 0 volts, instead of the +5 volts to which it is held when element 312a is selected. However, the charge on the capacitor 322 is not altered by this state of affairs, since the blocking diode 320 is reverse-biased by the voltage applied between contact 340 and line 316a, and thus it substantially prevents the discharge of capacitor 322. Of course, there will be a small change in the voltage on contact 340 when y line 316a changes voltage, due to the capacity divider effect between capacitors 322 and 324. However, since the capacitance 324 is much smaller than the capacitance 322, this change can be ignored in this discussion. In any case, this change is compensated for when line 136a goes to +5 volts on the next readout cycle.

The blocking diode 320 also prevents the voltage on capacitor 322 from being discharged when other rows are selected by multiplexer 332. As is indicated in Figures 15a and 15b, when multiplexer 332 selects an x line other than the line 314a, the line 314a is pulled-up to +5 volts by one of the pull-up resistors 328. It also shows that when the column select and drive circuitry 326 selects a y line other than the line 316a, the line 316a is supplied with 0 volts. This means that capactor 322 has +5 volts connected to its side which was formerly at 0 volts, driving the other side of the capacitor 322, connected to contact 340, to +10 volts, provided that the +5 volt charge previously placed on capacitor 322 has not been lost. During this state the blocking diode 320 inhibits charge on capacitor 322 from being lost to the y line 316a, which is at 0 volts.

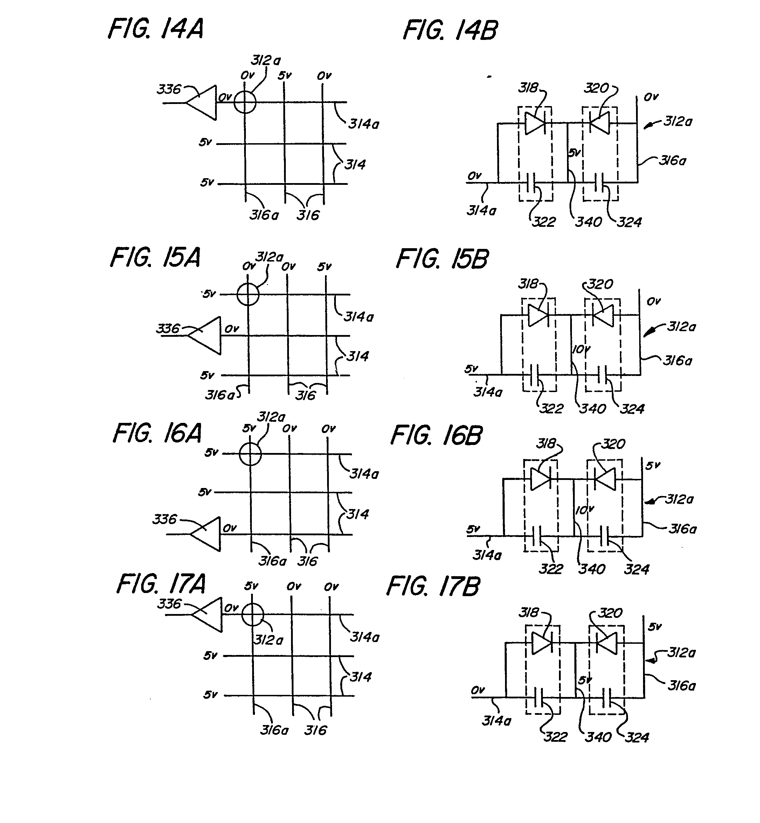

Figures 16a and 16b show what happens when the y line 316a is selected during a period when an x line other than line 314a is selected. In this case both the x and y lines of the element 312a are supplied with a positive +5 volts. As a result, the contact 340 is driven +10 volts, provided capacitor 322 still has the +5 volts charge initially supplied it. During this state the blocking diode 320 continues to inhibit the charge on capacitor 322 from being lost to the y line 316a.

Figure 17 shows what happens when the element 312a is again selected by both the multiplexer 332 and the select and drive circuit 326. In this case voltages are again applied to the element 312a which are identical to those shown in Figure 12b. However, no current flows to capacitor 322 unless that capacitor has lost charge since the last time it was selected, because unless such charge has been lost, the capacitor 322 already has a voltage equal to the voltage difference between y line 316a and x line 314a.

However, if light hits the diode 318 between the successive rechargings of its associated capacitance 322, something will be done to discharge that capacitance. This is because the diodes 318 are photoresponsive diodes, in which the reverse leakage current is greatly increased in the presence of light. When light hits the semiconductor material of such a diode, it generates electron-hole pairs which are swept by the field across such a diode in a direction that discharges the voltage generating that field. The more the light strikes a diode 318 between the recharging of its associated capacitor 322, the more the charge on that capacitor is lost. As a result of this lost charge, the voltage left on capacitor 322 is less than the voltage applied across it when the capacitor is next recharged, causing current to flow onto the capacitor 322 during its recharging. Because of capacitive coupling across capacitor 322, current flow to capacitor during its recharging causes current to flow in the capacitor's x line 314 to the amplifier 336, creating an signal at the output of that amplifier. The amount of such current is in proportion to the amount by which the capacitor 322 has been discharged by incident radiation since its previous recharging.

All of the photoresponsive elements 312 function in a manner similar to that of the element 312a just described. Thus the signal at the output of amplifier 336 varies in correspondence to the magnitude and time incidence of radiation incident upon the semiconductor material of each diode 318 during the entire period between its successive rechargings. In other words, the signal which results when a given photodiode is selected is not an instantaneous function of the amount of light falling on that photodiode during its selection, but rather is a function of all the radiation incident upon that photodiode during the entire period since its previous recharging. As a result, the apparatus of the present invention provides a much greater sensitivity and a much greater immunity to noise.

The current flow during the recharging of a given capacitor 322 is not constant. Instead it varies during the recharging period, with the amount of such current increasing rapidly to a maximum value at the beginning of each recharging period and then decreasing more slowly as the voltage on the capacitor approaches the voltage applied across it. Once the capacitor is completely charged, the current is limited to the relatively small instantaneous value of the reverse leakage current across its associated diode 318. Thus, the output signal produced by amplifier 336 in association with the selection of a given picture element is not a constant value, but rather a current pulse starting with a relatively rapid increase and ending with a relatively slow decrease. The actual rates of the increase and decrease depend upon many parameters, among them, the impedance of the driving circuitry, stray capacitance, and the time response characteristic of the diodes.

This output is used in different ways in different embodiments of the invention to indicate the amount of light which has hit each of the photosensitive elements. In some embodiments the output of amplifier 336 is integrated over the recharging period of each photosensitive element by means of an integrating amplifier. This is perhaps the most accurate method. In other embodiments, a sample and hold circuit is used to sample the magnitude of the output of amplifier 336 at a specified time during the recharging period of each picture element, such as the time at which that signal is at its maximum value. The resulting sampled value is then used as the indication of the amount of light which has hit the associated photoresponsive element since its last recharging. In other embodiments, the output of amplifier 336 is fed as a video signal to a cathode-ray-tube having a scanning pattern and rate similar to the array of photosensors 312. In such an embodiment, even though the amplitude of the video signal varies over the portion of a video line associated with a given photosensitive element, this is normally of little concern since the corresponding picture elements are close together on the CRT screen, and since such high frequency variations in the video signal can be reduced by the use of a low pass filter.

Referring now to Figures 18, 19 and 20, a radiation sensing appartus formed as an integrated circuit according to the present invention is shown. The radiation sensing apparatus shown in those figures comprises a substrate 341 formed of glass. In alternate embodiments of the invention other insulating substrates can be used, such as substrates formed of conductive materials, for example, stainless steel, coated with an insulator to provide the necessary electrical isolation for devices formed their surface. A layer 342 formed of molybdenum or another metal which forms a good ohmic contact with P+ type amorphous silicon alloys is deposited upon the substrate 341 by means such as sputtering, and then is patterned by photolithographic techniques to form the y address lines 316, the bottom electrodes 344 of the photoresponsive diode 318, and an extension of that bottom electrode which forms part of the address lines 314. Once the metal layer 342 has been patterned, three successive layers of amorphous semiconductor material are deposited upon the substrate 340, first a P+ layer 346 having a thickness of approximately 250 angstroms, then a substantially intrinsic, or I layer 348 having a thickness of approximately 3,500 angstroms, and then an N+ layer 350 having a thickness of approximately 250 angstroms. The deposited semiconductor material is preferably an amorphous semiconductor alloy including silicon. The amorphous silicon alloy can also include hydrogen and/or fluorine and can be deposited by plasma assisted chemical vapor deposition.

Amorphous silicon alloys can be deposited in multiple layers over large area substrates to form structures such as the integrated circuit shown in Figures 18, 19 and 20 in high volume, continuous processing systems. Continuous processing systems of this kind are disclosed, for example, in U.S. Patent No. 4,400,409, issued August 23, 1983 for "A Method Of Making P-Doped Silicon Films And Devices Made Therefrom"; U. S. Patent Application Serial No. 244,386, filed March 16, 1981 for "Continuous Systems For Depositing Amorphous Semiconductor Material"; U. S. Patent No. 4,410,558, issued October 18, 1983 for "Continuous Amorphous Solar Cell Production Systems"; U. S. Patent No. 4,438,723 issued March 27, 1984 for "Multiple Chamber Deposition And Isolation System And Method"; and U. S. Patent Application Serial No. 359,825, filed March 19, 1982 for "Method And Apparatus For Continuously Producing Tandem Amorphous Photovoltaic Cells".  As disclosed in these patents and applications, which are incorporated herein by reference, a substrate may be continuously advanced through a succession of deposition chambers, wherein each chamber is dedicated to the deposition of a specific material.

For example, in making the P-I-N layers 346, 348 and 350 shown in Figures 19 and 20, a single deposition chamber can be used for batch processing, or preferably, a multiple chamber system can be used wherein a first chamber is used for depositing a P+ type amorphous silicon alloy, a second chamber is used for depositing an intrinsic amorphous silicon alloy, and a third chamber is used for depositing a N+ type of amorphous silicon alloy.  Since each deposited alloy, and especially the intrinsic alloy, must be of high purity, the deposition environment in the intrinsic deposition chamber is preferably isolated from undesirable doping constituents within the other chambers to provide the diffusion of doping constituents into the intrinsic chamber.  In the previously mentioned patent applications, wherein the systems are primarily concerned with the production of photovoltaic cells, isolation between the chambers is accomplished by gas gates through which unidirectional gas flow is established and through which an inert gas may be swept about the web of substrate material.  In the previously mentioned patents and patent applications, deposition of the amorphous silicon alloy material onto the large area continuous substrate is accomplished by glow discharge decomposition process gases.  Among these processes, radio frequency energy glow discharge processes have been found to be suitable for the continuous production of amorphous semiconductor. An improved process for making amorphous semiconductor alloys and devices is disclosed in the copending Patent Application Serial No. 423,424, filed September 24, 1982 for "A Method Of Making Amorphous Semiconductor Alloys And Devices Using Microwave Energy", which is incorporated herein by reference. This process utilizes microwave energy to decompose the reaction gases to cause deposition of improved amorphous semiconductor materials. This process provides substantially increased deposition rates and reaction gas feed stock utilization. Microwave glow discharge processes can also be utilized in high volume mass production of devices, as disclosed in copending U.S. Patent Application Serial No. 441,280, filed Nov. 12, 1982, for "An Improved Apparatus For Manufacture Of Photovoltaic Devices", and to make layered structures, as is disclosed in copending U. S. Patent Application Serial No. 565,033, filed December 23, 1983, for "Method And Apparatus For Making Layered Amorphous Semiconductor Alloys Using Microwave Energy", both of which applications are incorporated herein by reference.

After the P-I-N layers 346, 348 and 350 have been deposited across the entire surface of the substrate 341, a thin layer 352 of a transparent conductor such as indium tin oxide is deposited on top of the N+ layer 350. Such a layer is preferably between 200 and 500 angstroms thick. Once the multilayered structure comprised of the P+ layer 346, the intrinsic layer 348, the N+ layer 350 and the indium tin oxide layer 352 has been formed over the entire surface of the substrate 340, photolithographic techniques are used to etch that combined layer into an array of diode pairs with one such diode pair for each photosensitive element 312 to be formed. Each of the diode pairs includes a large diode forming the photodiode 318 of its photosensitive element and having an area of approximately 200 microns by 200 microns. Each of the diode pairs also includes a much smaller diode forming the blocking diode 320 and having an area of approximately 30 microns by 30 microns. The bottom electrode of the photodiode 318 is formed by the molybdenum electrode 344, and the top electrode of that diode is formed by the ITO layer 352. Similarly, the bottom electrode of the blocking diode 320 is formed by a portion of the address line 316 and the top electrode of that diode is formed by a portion of the ITO layer 352. The relatively large overlapping area of the electrodes of photodiode 318 provide that diode with a relatively large capacitance. The much smaller area of the blocking diode 320 causes the capacitance 324 associated with its top and bottom electrodes to be much less.

Once the diodes 318 and 320 have been formed, the entire substrate 340 is covered with a thin transparent insulating layer 354. Preferably this insulating layer 354 is formed of polyimide, which can be placed over the substrate 340 and the structures formed upon it by roller, extrusion, or spin-coating. Alternatively, the insulating material in layer 354 could be formed from a deposited insulating material, such as silicon oxide or silicon nitride. Once the transparent layer 354 has been deposited, photolithographic techniques are used to form a contact opening 356 through a portion of layer 354 on top of photodiode 318 and a similar contact opening 358 through a portion of layer 354 on top of blocking diode 320. Similarly, a contact opening 360 is formed over the bottom right hand corner (as shown in Figure 18) of the bottom electrode 344 of photodiode 318, and another contact opening 362 is formed in the leftmost extension (as shown in Figure 18) of the bottom electrode 344 which forms part of its associated x line 314. When these contact openings have been formed, a layer of metal such as aluminum is deposited and patterned to form the connection 340 between openings 356 and 358 of each diode pair, connecting the cathodes of diodes 318 and 320. This top metal layer is also patterned to form a connecting link 364 between adjacent contact openings 360 and 362, so as to connect all of the bottom electrodes of the diodes 318 in a given row, and thus complete the address line 314 associated with that row. The metal contact 340 covers the blocking diode 320 from light, although this is not clearly shown in Figure 20, in which the vertical scale has been greatly exaggerated for purposes of illustration.

Once the integrated circuit has been formed in the manner described, it is preferable to coat it with a passivation layer (not shown), such as one formed of polyimide, to protect the top metal links 340 and 364 from oxidation.

The structure shown in Figures 18 through 20 forms an array of photosensitive elements 312 of the type shown in Figure 10. Since amorphous silicon alloys have very low dark conductivities and very high photoconductivities, the photodiodes 318 form very sensitive photoresponsive devices. As a result, the structure shown in Figures 18 through 20 forms an excellent photosensitive array.

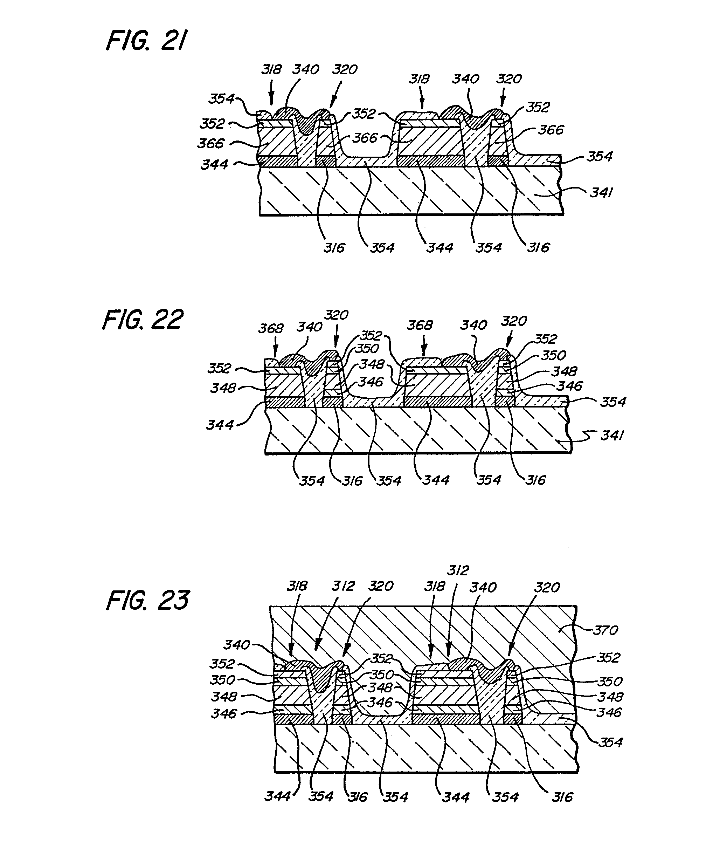

Referring now to Figure 21, an alternative embodiment of the invention is shown which is also electrically equivalent to the schematic diagram shown in Figure 10. The structure in Figure 21 is identical to that in Figure 20, except that its address lines 316, which form the bottom electrodes of its blocking diodes 320, and the bottom electrodes 344 of its photodiodes 318 are formed of a metal, such as palladium or platinum, which forms a Schottky barrier when placed in contact with intrinsic amorphous silicon. The structure of Figure 21 is also distinguished from that shown in Figure 20 by having only one layer 366 of intrinsic amorphous semiconductor material between the electrodes of its diodes 318 and 320, rather than the three P-I-N layers 346, 348 and 350 as in Figure 20. The platinum or palladium metal of the bottom electrodes of the diodes 318 and 320 form the anodes of those diodes, and the intrinsic silicon alloy layer 366 forms the cathodes, causing the diodes 318 and 320 shown in Figure 21 to have the same polarity as the PIN diodes shown in Figure 20. In embodiments in which it is desired to improve the ohmic nature of the contact between the top ITO electrodes 352 and the intrinsic layer 366, a thin layer of N+ silicon alloy is placed between that ITO electrode and the intrinsic layer.

Figure 22 shows another embodiment of the invention, which is identical to that in Figure 20 except the diode 318 has been replaced with a photoresistor 368. The photoresistor 368 is comprised of the single layer 348 of intrinsic amorphous silicon alloy, placed between a bottom metal electrode 344 and a top ITO electrode 352, both identical to those shown Figure 20. Photolithographic techniques prevent the P+ and N+ layers 346 and 350 used in the P-I-N blocking diode 320 from being deposited between the electrodes of photoresistor 368. Thus, the photoresistor 68 does not have diode characteristics. But since the intrinsic amorphous silicon alloy of layer 348 has a high dark resistivity while exhibiting a substantial photoconductivity, the device 368 functions much like the diode 318 for the purpose of the present invention. That is, in the absence of light it tends to maintain electrical charge placed upon the capacitor 322 formed by its top and bottom electrodes, and it discharges that electric charge in proportion to the amount of light which falls upon it.

Figure 23 shows an embodiment of the present invention for sensing x-ray images. This apparatus is virtually identical to that shown in Figure 20, with the exception that a layer of fluorescent material several hundred microns thick has been placed over it. Suitable fluroescent materials for such a layer include lanthanum oxysulfide with terbium, gadolinium oxysulfide with terbium, ytterbium oxysulfide with terbium, barium fluorochloride with europium, ytterbium oxides with gadolinium, or barium orthophosphate with europium. The thickness of this layer is not drawn to scale for purposes of convenience. When x-ray radiation falls upon the fluorescent layer 370 it generates light photons having a frequency which causes the generation of charge carriers in the photodiodes 318 of its associated photoresponsive elements. As a result, the amount of current required to recharge the capacitance of each of the photodiodes 18 is a function of the amount of x-ray radiation incident upon the portion of the fluorescent layer 370 overlying each such diode. Thus an array of photoresponsive elements 312 coated with the fluorescent layer 370 enables x-ray images to be electronically sensed.

In certain uses of x-ray imaging, such as certain medical uses, it is often desirable to have image sensing elements which are accurate over a broad dynamic range. With the present invention such accuracy can be achieved by the use of calibration techniques which measures the readings produced by each photosensitive element 312 in response to known levels of incident radiation and use a computer having such calibration information to adjust the output of each photosensitive element in correspondence with such calibration data. For maximum results such calibration should compensate not only for the differing photoresponsive characteristics of each photodiode 318, but also for the light-independent reverse leakage current of each such photodiode. Typically photodiodes of the type described in regard to Figure 18 through 20 have a leakage current in the dark which is less than one thousandth that of the photo-induced leakage current which they generate in normal room light. This difference is great enough so that the output signal produced can be used for many purposes without compensation for such light-independent leakage current. But in situations where a high dynamic range of light sensitivity is required, a computer is used to adjust for such leakage current.

In order to achieve a desired range of light sensitivity it is also important to choose the proper length of time between the recharging of the picture elements 312. A good length of time is one that is just long enough to allow the recharging voltage placed on the element to be completely discharged by light at the top end of the range of light intensities which the element is intended to measure. If the time is shorter than this, the time during which a photodiode has to integrate light incident upon it will not be enough to produce a maximum signal. If the time is longer, the capacitor 322 will be totally discharged by a whole sub-range of light intensities falling within the range of intensities to be measured, having the undesirable effect of making it impossible to distinguish between any such light intensities falling within that sub-range. If the time between recharging is made extremely long, the light-independent leakage current will totally discharge the capacitors 322 by itself, making it impossible to measure any signal produced by the incidence of light on the photodiodes.

In some large arrays constructed in the general manner shown in Figure 10, the time between recharging is reduced by connecting the pull-up resistors 328 attached to each x line to ground instead of to +5 volts. This causes all the photoresponsive elements 312 in a given column to be recharged in parallel each time the y line 316 associated with that column is supplied with +5 volts. As a result, each element 312 is recharged once during the scanning of each row. The resistance of the resistors 328 is sufficiently large so that the recharging current which flows to ground from unselected x lines is isolated from the recharging current which flows to the amplifier 336 from the selected x line. This enables the recharging currents in the selected row to be read independently of the recharging currents in non-selected rows. This recharging method is particularly suitable for use with large high-resolution arrays used in contact document copier of the type discussed below.

One of the advantages of the present invention is that it enables a sensing apparatus to be constructed in which the individual elements can be randomly addressed. For example, in the apparatus disclosed in Figure 10, any given photoresponsive element 312 can be read by: a) selecting its associated x and y lines to charge it, b) subsequently selecting those lines again after a known period of time has elapsed to recharge it, and, c) measuring the current that flows during such recharging. This random addressability means that the time between recharging can be selectively varied over different portions of the display to vary the range of light intensity over which those portions are responsive. Such random addressibility also allows a large array to be scanned quickly by reading only a representative sample of its photoresponsive elements, while allowing the option for more detailed image scanning when and where desired.

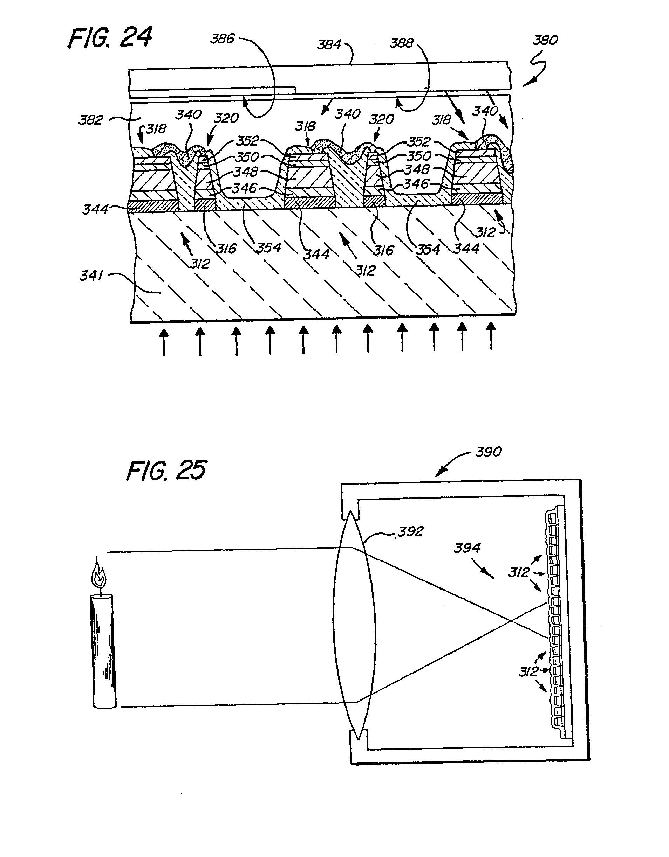

Figure 24 shows an image sensing apparatus 380 according to an embodiment of the invention which is designed for use in forming images of documents placed in close proximity to its array of photosensitive elements. The apparatus 380 includes an array of photosensitive elements 312 similar to those shown in Figure 20. However, the glass substrate 340 of apparatus 380 is substantially thicker than shown in Figure 20, so that documents and books can be placed upon it without its being broken by their weight. In addition, the apparatus 380 has placed over its insulating layer 354 and its top metal contacts 340 and 364 a layer 382 of sputtered silicon dioxide ($SiO_2$) or silicon nitride ($Si_3Cn_4$) to form a hard, transparent, substantially flat oxide layer approximately 100 microns thick. The apparatus 380 shown in Figure 24 is designed for copying opaque documents, such as the document 384 partially shown in Figure 24. The photosensitive elements 312 are spaced sufficiently far apart to allow a substantial amount of the light entering the substrate 340 from its backside, as indicated by arrows in Figure 24, to pass between such elements, and illuminate the surface of a document facing the transparent oxide surface 382. Each individual photosensitive element 312 responds primarily to the amount of light reflected from the portion of document 384 placed closest to it. For example, in Figure 24 the document 384 is shown as having a darkened portion 386 upon its bottom surface, such as part of an inked letter of text. Since relatively little light is reflected from this darkened portion 386, the photosensitive elements 312 beneath it receive little reflected light. However, a relatively large amount of light is reflected from the light portion 388 on the bottom surface of document 384, and thus the photsensitive elements 312 below that portion receive more light. It is important that the metal which forms the bottom electrodes of the diodes 318 and 320 be over 2,000 angstroms thick, so as to prevent radiation from below those diodes from impinging directly upon them.

In order to form accurate copies of documents such as business letters and pages from books and magazines, it is desirable that the sensing apparatus 380 have a resolution of at least 4 points per millimeter, and, preferably, of 8 points per millimeter. To form a sensor with a resolution of 8 points per millimeter the photosensitive elements 312 should be spaced every 125 microns, and the oxide layer 382 should be no more than approximately 100 microns thick. One of the advantages of the present invention is that it can be used to form an array of photosensitive elements that is at least 11" long and 8-1/2" wide as a single integrated circuit. This is because the deposited semiconductor materials used to form the image sensing apparatus of the present invention can be deposited over large areas, as is described above, and do not require crystalline substrates, which are presently limited in size. Thus the present invention makes it possible to make a solid state document imaging device with no moving parts, with the imaging element formed as one integrated circuit on a single glass substrate.

Referring now to Figure 25, an incident radiation sensing apparatus 390 according to the present invention is shown in schematic form. The apparatus 390 includes a focusing means, such as a lens 392 for focusing a light image upon an array 394 of photosensitive elements 312. In the embodiment shown, the array of photosensitive elements 312 is a structure such as that shown in Figures 18 through 20. Experiments have shown that such photosensitive arrays have sufficient sensitivity to produce images of objects illuminated in normal room light when scanned at a video rate and used in conjunction with a lens having an aperture of F4. Thus the present invention is suitable for use in video cameras as well as electronic still cameras.

From the foregoing it is apparent that incident radiation sensing apparatuses according to the present invention can be employed in a variety of radiation sensing applications including not only X-ray imaging, document copying, and electronic photographs, but also any other application in which it is desirable to sense a spatial distribution of radiation. It is recognized, of course, that those skilled in the art may make various modifications or additions to the preferred embodiments chosen to illustrate the invention without departing from the spirit and scope of the present contribution to the art.

CLAIMS

1. An apparatus (10;12;310;380;390) capable of providing electrical signals representative of an image, said apparatus being of the type having a first plurality of address lines (20,22,24;150;316), a second plurality of address lines (26,28,30;126,314) electrically insulated from and crossing at angle to said first plurality of address lines to form a plurality of crossover points (70-86;152;311), and a photosensor (32-48;120;318;368) arranged to receive said image and comprising a light sensitive element associated with at least some of said crossover points, each said element being adapted to effect a detectable change in electrical characteristic responsive to incident light and being coupled to one address line of one of said plurality of address lines; said apparatus being characterized by an isolation means, comprising diodes (122;320), associated with each said light sensitive element to facilitate selective addressing of said light sensitive elements by the application of read potentials to respective pairs of said first and second pluralities of address lines.

2. An apparatus (10;12) as defined in Claim 1 further characterized by said light sensitive elements (32-48) comprising photovoltaic cells (120).

3. An apparatus (Figure 22) as defined in Claim 1 further characterized by said light sensitive elements comprising photoresistors (368).

4. An apparatus (10;12;310;380;390) as defined in Claim 1 further characterized by said light sensitive elements (32-48;120;318;368) being formed from deposited semiconductor material (128,130;132;346,348,350;366).

5. An apparatus (10;12;310;380;390) as defined in Claim 4 further characterized by said deposited semiconductor material (128,130;132;346,348,350;366) being an amorphous semiconductor alloy.

6. An apparatus (10;12;310;380;390) as defined in Claim 5 further characterized by said amorphous semiconductor alloy (128,130;132;346,348,350;366) being an alloy of silicon including hydrogen or fluorine.

7. An apparatus (10;12) as defined in Claim 5 further characterized by said light sensitive elements (32-48) comprising photovoltaic cells (120) including a first doped region (128), a substantially intrinsic region (130), and a second doped region (132) of opposite conductivity with respect to said first doped region.

8. An apparatus (10;12;310;380;390) as defined in Claim 1 further characterized by said diodes (122;320) being formed from deposited semiconductor material (136,138,140;346,348,350;366).

9. An apparatus (10;12;310;380;390) as defined in Claim 8 further characterized by said deposited semiconductor material (136,138,140;346,348,350;366) is an amorphous semiconductor alloy.

10. An apparatus (10;12;310;380;390) as defined in Claim 9 further characterized by said amorphous semiconductor alloy (136,138,140;346,348,350;366) being an alloy of silicon including hydrogen and fluorine.

11. An apparatus (10;12;310;380;390) as defined in Claim 9 further characterized by said diodes (122;320) including a first doped region (136;346), a substantially intrinsic region (138;348), and a second doped regions (140;350) of opposite conductivity with respect to said first doped region.

12. An apparatus (10;12;310;380) capable of providing electrical signals representative of an image having light (108;388) and dark (106;386) portions carried by an opaque image-bearing member (14;384), said apparatus characterized by:

a transparent substrate (18;341);

a first set of address lines (20,22,24;150;316);

a second set of address lines (26,28,30;126,314) spaced from and crossing at an angle to said first set of address lines to form a plurality of crossover points (70-86;152;311);

a plurality of light sensitive elements (32-48;120;190;318;368;) formed and distributed on said substrate and in spaced apart relation, each light sensitive element being associated with a given one of said crossover points and arranged to effect a detectable change in electrical characteristic in response to receipt of incident light;

an isolation device (50-66;122;192;320) associated with each said light sensitive element to facilitate the selective addressing and detection of the electrical conductivity of each said light sensitive element by the application of read potentials to respective pairs of said first and second sets of address lines; and

transparent cover means (68;382) overlying said light sensitive elements and including a substantially planar surface opposite said light sensitive elements for receiving said image-bearing member thereon in close juxtaposed relation to said light sensitive elements.

0163956

-48-

13. An apparatus (10;12) as defined in Claim 12 further characterized by said light sensitive elements (32-48) comprising photovoltaic cells (120).

14. An apparatus (10;12; Figure 22) as defined in Claim 12 further characterized by said light sensitive elements (32-48;368) comprising photoresistors (190;368).

15. An apparatus (10;12;310;380) as defined in Claim 12 further characterized by said light sensitive elements (32-48;120;190;318;368) being formed from deposited semiconductor material (128,130,132;200;346,348,350;366).

16. An apparatus (10;12;310;380) as defined in Claim 15 further characterized by said deposited semiconductor material (128,130,132;200;346,348,350;366) being an amorphous semiconductor alloy.

17. An apparatus (10;12;310;380) as defined in Claim 12 further characterized by said isolation devices (50-66;122;320) comprising diodes (122;320).

18. An apparatus (10;12) as defined in Claim 12 further characterized by said isolation devices (50-66) comprising field effect transistors 192.

19. An apparatus (10;12;310;380) as defined in Claim 12 further characterized by said isolation devices (50-66;122;192;320) being formed from deposited semiconductor material (136,138,140;200;346,348,350;366).

20. An apparatus (10;12;310;380) as defined in Claim 19 further characterized by said deposited semiconductor material (136,138,140;200;346,348,350;366) being an amorphous semiconductor alloy.

21. An apparatus (10;12;310;380) as defined in Claim 12 further characterized by said cover means (68;382) being arranged for proximity focusing said

0163956

-49-

image onto said light sensitive elements (32-48;120;190;318;368).

22. An apparatus (10;12;310;380) as defined in Claim 12 further characterized by including a light source (16) arranged for projecting light onto said image-bearing member (14;384) on the side thereof immediately adjacent said cover member (68;382).

23. An apparatus (10;12;310;380) as defined in Claim 22 further characterized by said light source (16) being arranged for projecting light of different colors onto said image-bearing member (14;384).

24. An apparatus (10;12;310;380) as defined in Claim 23 further characterized by said light source (16) including red, blue, and green light sources.

25. An apparatus (10;12;310;380) as defined in Claim 12 further characterized by said light sensitive element (32-48;120;190;318;368) having light shields (124;198;344) formed between them and the transparent substrate (18;341) so that light shining through the substrate to illuminate said image tends not to hit said light sensitive elements until it reflects off said image.

26. A method of generating electrical signals representative of an image formed by high (106;386) and low (108;388) optical density portions on one said of an image-bearing member (14;384), said method being characterized by including the steps of:

providing an array of light sensitive elements (32-48;120;190:318;368) capable of effecting a detectable change in an electrical characteristic in response to the receipt of light thereon in spaced apart substantially coplanar relation;

placing said image-bearing member over said array of elements with said one side of said member adjacent said array of elements;

projecting light onto said one side of said member so that the image portions of low optical density reflect light onto said elements adjacent thereto and the image portions of high optical density reflect substantially less light onto said elements adjacent thereto than reflected by said portions of low optical density; and

selectively applying read potentials to said light sensitive elements for detecting the electrical characteristic of said elements and deriving an electrical signal for each element representative of the optical density of the image portion adjacent thereto.

27. A method as defined in Claim 26 further characterized by said one side of said image-bearing member (14;384) being placed in closely spaced juxtaposed relation to said array of light sensitive elements (32-48;120;190;318;368) and wherein said step of projecting light onto said one side of said image-bearing member includes projecting light through spaces between said light sensitive elements.

28. A method as defined in Claim 26 further characterized by the additional step of sequentially projecting different colored light onto said image-bearing member (14;384).

29. An apparatus (10;12;310;380) for providing electrical signals representative of an image projected thereon, said apparatus being of the type having an array of spaced apart light sensitive elements (32-48;120;190;318;368) formed from deposited semiconductor material (128,130,132;200;346,348,350;366) and arranged for receiving said image, said elements being capable of effecting a detectable electrical characteristic responsive to the intensity of light received thereon from said image; and isolation means (50-66;122;192;320) for enabling the selective detection of said electrical characteristic of each said element, said apparatus characterized by each of said light sensitive elements being formed from at least one layer of said semiconductor material (128,130;132;200;346,348,350;366) deposited over a first conductive layer (124;198;344) and covered by a second conductive layer (134;208;352) deposited over it, at least one of said first and second conductive layers being light transparent.

30. An apparatus (10;12;310;380) as defined in Claim 29, further characterized by said isolation means (50-66;122;192;320) being formed from the same at least one deposited layer of semiconductor material (128,130,132;200;346,348,350;366) as said light sensitive elements.

31. An apparatus (10;12) for providing electrical signals representative of an image projected thereon, said apparatus being of the type having an array of spaced apart light sensitive elements (32-48) formed from deposited semiconductor material (128,130,132) and arranged for receiving said image, said elements being capable of effecting a detectable electrical characteristic responsive to the intensity of light received thereon from said image, and isolation means (122) for enabling the selective detection of said electrical characteristic of each said element; said apparatus characterized by said light sensitive elements comprising photovoltaic cells (120).

32. An apparatus (Figures 8, 9, and 23) for providing electrical signals representative of an image formed by projecting thereon a spatially varying intensity distribution of a first form of energy having incident energy in a first range, said apparatus characterized by

0163956

-52-

an array of energy sensitive elements
(120;190;318) , said elements being responsive to the
impingement of a second form of energy in a second
energy range different from said first energy range
for effecting a detectable electrical characteristic;

means (121;191;370) overlying said energy
sensitive elements, said means responsive to said
spatially varying distribution of said first form of
energy, for converting said first form of energy to
said second form of energy; and

means (122;192;320) for enabling the
selective detection of said electrical characteristic
of said energy sensitive elements.

33. An apparatus (Figures 8, 9 and 23) as
defined in Claim 32 further characterized by each said
energy sensitive element (120;190;318) including
deposited semiconductor material.

34. An apparatus (Figures 8, 9, and 23) as
defined in Claim 32 further characterized by said
means for converting (121;191;370) being arranged to
convert electromagnetic energy in the first energy
range to electromagnetic energy in the second energy
range.

35. An apparatus (Figures 8, 9 and 23) as
defined in Claim 34 further characterized by said
electromagnetic energy in the first energy range
corresponding to X-rays having photon energies in the
first energy range.

36. An apparatus (Figures 8, 9, and 23) as
defined in Claim 34 further characterized by said
electromagnetic energy in the second energy range
corresponding to visible light having photon energies
in the second energy range.

37. An apparatus (Figures 8, 9, and 23) as
defined in Claim 32 further characterized by said
converting means (121;191;370) being arranged to

725.2

-53-

convert an accelerated beam of particles with energies in the first energy range into electromagnetic energy with photon energies in the second energy range.

38. An apparatus (Figures 8, 9 and 23) as defined in Claim 37 further characterized by said electromagnetic energy corresponding to visible light.

39. An apparatus (Figures 9 and 23) as defined in Claim 32 further characterized by said electrical characteristic being the electrical conductivity of said elements.

40. An apparatus (Figure 8) as defined in Claim 32 further characterized by said energy sensitive elements (120) comprising photovoltaic cells.

41. An apparatus (Figures 8, 9, and 23) as defined in Claim 32 further characterized by said enabling means (122;192;320) including a plurality of electrical conductors (20,22,24;150;316;26,28,30;126,314), and at least one isolation means (122;192;320) between a given energy sensitive element and at least one of said conductors.

42. An apparatus (Figures 8 and 23) as defined in Claim 41 further characterized by said isolation means (122;320) including a diode (122;320) associated with each said energy sensitive element.

43. An apparatus (Figures 8 and 23) as defined in Claim 42 further characterized by each said diode (122;320) being formed of deposited semiconductor material (136,138,140;346,348,350).

44. An apparatus (Figure 9) as defined in Claim 41 further characterized by said isolation means (192) incuding a thin film field effective transistor associated with each of said energy sensitive elements (190).

45. An apparatus (Figures 8 and 9) as defined in Claim 34 further characterized by said converting means comprising layer of phoshorescent material (121b,191b).

46. An apparatus (Figures 8 and 9) as defined in Claim 45 further characterized by said converting means including:

a layer of transparent insulating material (121a,191a); and

a deposited metal layer (121c, 191c) with said layer (121b, 191b) of photphorescent material positioned therebetween.

47. An apparatus (Figure 23) as defined in Claim 34 further characterized by said converting means (370) comprising a layer of fluorescent material.

48. Incident radiation sensing apparatus (310;380;390) of the type having a substrate (341), an array of photosensitive elements (312) formed as an integrated circuit on said substrate; said apparatus being characterized:

a) by each of said photosensitive elements having:

i) capacitor means (322) for storing charge;

ii) conductive means (314,316,326,332,334,336) for charging said capacitor means to a preselected magnitude;

iii) blocking means (320) for inhibiting the discharge of charge stored on said capacitor means; and

iv) photoresponsive means (318;368) formed from deposited semiconductor material (346,348,350;366) for generating charge carriers at a rate responsive to the intensity of radiation incident upon said photoresponsive means, said photoresponsive means being connected to said capacitor means so that said charge carriers reduce the magnitude of the charge on said capacitor means as a function of the magnitude of, and the time incidence of, said incident radiation; and

b) by said apparatus further including means (314,316,326,332,334,336,338) for sensing the magnitude of charge remaining on a given said capacitor means a preselected period of time after its said charging by said conductive means, thereby to produce a signal corresponding to the time integral of the magnitude of the incident radiation impinging on said photoresponsive means connected to said given capacitor means during said preselected period of time.

49. Incident radiation sensing apparatus (310;380;390) as defined in Claim 48 further characterized by:

a plurality of intersecting lines (314,316) being formed on said substrate; and

said conductive means (314,316,326,332,334,336) associated with each photosensitive element (312) including a pair of such intersecting lines.

50. Incident radiation sensing apparatus (310;380;390) as defined in Claim 49, further characterized by said means (314,316,326,332,334,336,338) for sensing the magnitude of charge also including said pair of intersecting lines (314,316) associated with each photosensitive element (312).

51. Incident radiation sensing apparatus (310;380;390) as defined in Claim 49, further characterized by:

0163956

said plurality of intersecting lines (314,316) including a plurality of generally parallel x lines (314) and a plurality of generally parallel y lines (316) crossing said x lines;

said photosensitive elements (312) being formed at the crossings of said x and y lines; and

said conductive means (314,316,326,332,334,336) associated with each photosensitive element including one x line and one y line.

52. Incident radiation sensing apparatus (310;380;390) as defined in Claim 48, further characterized by said blocking means (320) being connected between said capacitor means (322) and at least a part of said conductive means (316) so as to inhibit the discharge of said capacitor means through said conductive means.

53. Incident radiation sensing apparatus (310;380;390) as defined in Claim 48, further characterized by said blocking means (320) including a semiconductor blocking junction (346-348,348-350,366-344).

54. Incident radiation sensing apparatus (310;380;390) as defined in Claim 48, further characterized by:

said conductive means · (314,316,326,332,334,336) for charging including means (314,316,326,332,334,336) for recharging said capacitor means (322) after the expiration of said preselected period of time; and

said means (314,316,326,332,334,336,338) for sensing the magnitude of charge including means (336,338) for sensing the amount of current which flows during said recharging of said capacitor means.

0163956

-57-

55. Incident radiation sensing apparatus (310;380;390) as defined in Claim 48, further characterized by:

said capacitor means (322) being a capacitor formed of two spaced apart electrodes (344,352); and

said deposited semiconductor material (346,348,350;366) of said photoresponsive means (318,368) being located between, and is electrically connected to, said electrodes.

56. Incident radiation sensing apparatus (310;380;390) as defined in Claim 56, further characterized by:

said electrodes (344;352) of said capacitor (322) being vertically arrayed with respect to each other and said substrate (341); and

said semiconductor material (346,348,350;366) of said photoresponsive means (318;368) being deposited between said electrodes (344;352) so as to act as a dielectric between them.

57. Incident radiation sensing apparatus (310;380;390) as defined in Claim 48, further characterized by said semiconductor material (346,348,350;366) of said photoresponsive means (318;368) including an amorphous semiconductor alloy.

58. Incident radiation sensing apparatus (310;380;390) as defined in Claim 57, further characterized by said amorphous semiconductor alloy (346,348,350;366) being an alloy of silicon including hydrogen or fluorine.

59. Incident radiation sensing apparatus (310;380;390) as defined in Claim 55, further characterized by said deposited semiconductor material (346,348,350;366) forming at least one semiconductor

-58-

blocking junction (346-348;348-350;344-366) which inhibits the discharge of said capacitor 322 in the absence of radiation incident upon said semiconductor material.

60. Incident radiation sensing apparatus (310;380;390) as defined in Claim 59, further characterized by said deposited semiconductor material (346;348;350) being formed in at least two layers (346;348;350) having their Fermi levels positioned differently relative to the energy levels of their conduction and valance bands, so as to form said blocking junction (346-348;348-350) in said layers.

61. Incident radiation sensing apparatus (310;380;390) as defined in Claim 60, further characterized by said deposited semiconductor material (346;348;350) including three layers (346;348;350), including a bottom layer (346) closest to said substrate formed of a first conductivity type, an intermediate layer (348) formed of a substantially intrinsic type, and a top layer (350) formed of a second conductivity type, said first and second conductivity types being selected so the semiconductor junctions between said layers form said at least one semiconductor blocking junction (346-348;348-350).

62. Incident radiation sensing apparatus (Figure 21) as defined in Claim 59, further characterized by at least one of said electrodes (344) of said capacitor (322) being formed of metal which forms said blocking junction (344-366) with said semiconductor material (366) of said photoresponsive means (368).

63. Incident radiation sensing apparatus (Figure 22) as defined in Claim 56, further characterized by said deposited semiconductor material (348) of said photoresponsive means (368) forming a photoresistor.

64. Incident radiation sensing apparatus (Figure 22) as defined in Claim 63, further characterized by said deposited semiconductor material (348) between said electrodes (344;352) of said capacitor (322) being formed of a single layer of substantially intrinsic amorphous semiconductor alloy (348).

65. Incident radiation sensing apparatus (Figure 24) as defined in Claim 48, further characterized by being for use in forming an image of a document (384) placed in close proximity to said array of photosensitive elements (312), said sensing apparatus including a transparent spacing means (382) for positioning said document, when it is placed against said spacing means, in spaced-apart proximity to said array of photosensitive elements, sufficiently close to said array so that individual photosensitive elements of said array sense the amount of light leaving the surface of the portions (386;388) of the document placed in close proximity to them.

66. Incident radiation sensing apparatus (Figure 24) as defined in Claim 65, further characterized by said integrated circuit (380) in which said array is formed being a large area integrated circuit with said array of photosensitive elements (312) being at least 11 inches long and 8-1/2 inches wide.

67. Incident radiation sensing apparatus (Figure 24) as defined in Claim 65, further characterized by said integrated circuit (380) being formed so that light can pass through said integrated circuit between said photosensitive elements (312) to illuminate a portion of a document (384) placed in close proximity to said photosensitive elements without directly illuminating said photosensitive elements, whereby individual photosensitive elements sense the amount of light reflected from the portion (386;388) of the document placed in close proximity to them.

68. Incident radiation sensing apparatus (Figure 23) as defined in Claim 48, further characterized by being for use in sensing an X-ray image, said apparatus further comprising converting means (370) overlying said photosensitive elements (312) for producing radiation in response to the impingement of X-rays upon said converting means, said produced radiation having a frequency which causes the generation of charge carriers in said photoresponsive means (318) of said photosensitive elements, whereby a given photoresponsive means of a given photosensitive element generates charge carriers in correspondence to the amount of X-ray radiation incident upon a portion of said converting means overlying it.

69. Incident radiation sensing apparatus (Figure 23) as defined in Claim 68, further characterized by said converting means (370) comprising a layer of fluorescent material placed in close proximity to said array of photosensitive elements (312).

70. Incident radiation sensing apparatus (Figure 25) as defined in Claim 48, further characterized by said apparatus including a focusing means (392) for focusing a light image upon said array of photosensitive elements (312).

71. A method of sensing a spacial distribution of radiation characterized by:

using a plurality of conductive address lines (314,316) to place a charge across each of a plurality of capacitor means (322);

using a blocking means (320) to inhibit said charge from flowing off said capacitor means to through said conductive address lines;

using a separate photoresponsive means (318;368) formed of deposited semiconductor material (346,348,350;366) which is placed electrically in parallel with each of said capacitor means to discharge the capacitor means at a rate corresponding to the intensity of incident radiation upon said photoresponsive means; and

measuring the charge remaining on each of said plurality of capacitor means a given time after its charging to obtain a measurement of the time integral of the intensity of radiation which has been incident on its associated photoresponsive means since that charging.

72. A method as in Claim 71, further characterized by said using of a separate photoresponsive means (318) including using a photodiode (318) formed of deposited semiconductor material (346,348,350) as said photoresponsive means, and having said photodiode connected in parallel with said capacitor means (322) so that it is reverse biased by said charge placed across its associated capacitor means.

73. A method as in Claim 71, further characterized by said measuring of charge remaining on each of said plurality of capacitor means (322) including recharging each of said capacitor means using said address lines (314,316) and measuring the current flow through an address line during the recharging of each capacitor means to determine the amount by which that capacitor means had been discharged.

74. A method as in Claim 73, further characterized by;

said address lines (314,316) forming an x - y array of address lines, and;

both said placing of a charge across each of a plurality of capacitor means (322) and said recharging each of said capacitor means including using said x - y array of address lines to charge and recharge individual capacitor means by use of x - y addressing.

75. An apparatus (10;12;310;380;390) capable of providing electrical signals representative of an image, said apparatus being of the type having a first plurality of address lines (20,22,24;150;316), a second plurality of address lines (26,28,30;126,314) electrically insulated from and crossing at angle to said first plurality of address lines to form a plurality of crossover points (70-86;152;311), and a photosensor (32-48;120;318;368) arranged to receive said image and comprising a light sensitive element associated with at least some of said crossover points, each said element being adapted to effect a detectable change in electrical conducitivity responsive to incident light and being coupled to one address line of one of said plurality of address lines; said apparatus being characterized by an isolation means (122;192;320) associated with each said light sensitive element to facilitate selective addressing of said light sensitive elements by the application of read potentials to respective pairs of said first and second pluralities of address lines.

FIG. 1

FIG. 2

0163956

FIG. 3

FIG. 4

0163956

FIG. 5

FIG. 6

FIG. 7

FIG. 8

FIG. 9

FIG. 10

COLUMN SELECT AND DRIVE CIRCUITRY

MULTIPLEXOR

FIG. 11A

FIG. 11B

FIG. 12A

FIG. 12B

FIG. 13A

FIG. 13B

FIG. 14A

FIG. 14B

FIG. 15A

FIG. 15B

FIG. 16A

FIG. 16B

FIG. 17A

FIG. 17B

*Fig*

0163956

**FIG. 18**

**FIG. 19**

**FIG. 20**

FIG. 21

FIG. 22

FIG. 23

0163956

**FIG. 24**

386  384  388  380

382  340  320  318  340  320  318  340
318  352  352
350  350
348  348
346  346
344

341  312  316  354  344  312  316  354  344  312

**FIG. 25**

390

392  394  312

312